Europäisches Patentamt

European Patent Office

Office européen des brevets

(11) Publication number: **0 269 193 B1**

(12) **EUROPEAN PATENT SPECIFICATION**

(45) Date of publication of patent specification: **15.01.92**  (51) Int. Cl.⁵: **H03L 7/10**

(21) Application number: **87303882.2**

(22) Date of filing: **30.04.87**

(54) Phase locked ocillator circuit.

(30) Priority: **27.10.86 US 923784**

(43) Date of publication of application:
**01.06.88 Bulletin 88/22**

(45) Publication of the grant of the patent:
**15.01.92 Bulletin 92/03**

(84) Designated Contracting States:
**DE FR GB NL**

(56) References cited:
**US-A- 4 542 351**
**US-A- 4 567 448**

**IBM TECHNICAL DISCLOSURE BULLETIN, vol. 29, no. 2, July 1986, pages 553-554; "Phase-locked oscillator charge pump"**

(73) Proprietor: **SEAGATE TECHNOLOGY INTERNA-TIONAL**
**c/o Maples & Calder, P.O. Box 309**
**Georgetown, Grand Cayman Island(KY)**

(72) Inventor: **Cronch, Robert Douglas**
**Apartment 233 12821 North Stratford Drive**
**Oklahoma City OK 83120(US)**
Inventor: **Koudele, Larry Joseph**
**12124 Cliff Rose Drive**
**Oklahoma City OK 73132(US)**

(74) Representative: **Miller, Joseph et al**
**J. MILLER & CO. Lincoln House 296-302 High Holborn**
**London WC1V 7JH(GB)**

## Description

This invention relates to phase locked oscillator circuits.

Phase locked oscillator circuits aid in the recovery of data previously stored at discrete time intervals. In many instances the original storage process or later recovery process are not perfectly timed. As a result, a recovered data pulse may not occur at a proper time window. When this occurs, it is necessary to adjust the recovery time windows so that the recovered data pulse occurs during the proper discrete time window, thereby duplicating the data as originally stored.

Phase locked oscillator circuits typically include a voltage controlled oscillator which produces the time windows. Other circuitry in the phase locked oscillator circuits shift the position of the time windows so that the recovered data pulse falls into the proper time window. Ideally, when a data pulse occurs within a particular time window it duplicates the original data. If a data pulse falls into the wrong time window an error results. In order to prevent such errors the time windows and the discrete time intervals are synchronised. If the time windows are not synchronised with the discrete time intervals, the pulse may fall into the wrong time window resulting in a read error. Before data is read, a number of uniformly spaced pulses are provided to allow the phase locked oscillator circuit to shift the time windows so that they are in synchronisation with the discrete time intervals.

The uniformly spaced pulses are referred to as a PLO sync zone, and are usually recorded at the header of a track or track sector. The process of the phase locked oscillator circuit synchronising the time windows to the discrete time intervals is referred to as locking on. Under some circumstances, presently available phase locked oscillator circuits function as designed but are unable to synchronise the time windows and the discrete time intervals during the PLO sync zone. For example, in the presence of jitter, when the even pulses occur slightly after the discrete time interval and the odd pulses occur slightly before the discrete time interval, some phase locked oscillator circuits perform as designed yet produce a continuous pattern of read errors.

One solution to enable the phase locked oscillator circuit to lock on in the presence of jitter or other similar situations is to phase lock on every other pulse. However, this produces the undesirable result of increasing the normal phase lock on time due to loss of loop gain in the phase locked oscillator circuit. When the lock on time increases, the length of the PLO sync zone increases thereby decreasing the amount of memory space available on the media for data.

The present invention seeks to provide a phase locked oscillator circuit that will quickly synchronise time windows with discrete time intervals in the presence of jitter and similar conditions while maintaining loop gain of the circuit.

IBM Technical Disclosure Bulletin, Vol. 29, No. 2, July 1986, pages 553 to 554 "Phase-locked oscillator charge pump" discloses a PLO charge pump providing fast synchronisation between regenerated clock and read data. When the PLO is turned on in the "first sync" mode, the charge pump increases by a constant factor the amount of the control current supplied to the controlled oscillator.

According to one aspect of the present invention there is provided a phase locked oscillator circuit for phase locking a clock signal to the phase of a series of sync pulses, characterised by comprising: clock signal producing means for producing a clock signal having a frequency responsive to a first signal; a loop filter for applying the first signal to clock signal producing means in response to a current signal, comparing means including a charge pump for adding to or subtracting from the loop filter second signal in response to the phase relationship between the clock signal and the series of sync pulses; means for generating a third signal of decreasing value during the presence of the sync pulses; means for providing a constant current fourth signal, and a current mirror for producing the second signal in response to the third signal and the fourth signal.

Preferably a summation of the third and fourth signals determines the magnitude of a frequency change produced by the first signal.

In the illustrated embodiment said means for generating the third signal comprises a substantially constant signal portion, shorting means for shorting a signal to ground upon every other sync pulse, and a decaying signal portion electrically connected to the shorting means so that the decaying signal portion drops to zero on every other sync pulse, the substantially constant signal portion and the decaying signal portion being summed to produce the third signal. Said shorting means may include a flip-flop acting as a switch which alternates between an open position and a closed position connected to ground.

The comparing means may be arranged to produce the second signal when the clock signal is out of phase with the series of sync pulses.

Preferably said clock signal producing means is a voltage controlled oscillator the first signal produced by the means for adjusting the level of current varies the voltage in the circuit near the voltage controlled oscillator thereby varying the frequency of the read clock signal.

The voltage controlled oscillator circuit may be such that the voltage in the circuit near the voltage controlled oscillator increases in response to the read frequency increment signal to increase the frequency of the read clock signal and the voltage in the circuit near the voltage controlled oscillator decreases in response to the read frequency decrement signal to decrease the frequency of the clock signal.

The invention is illustrated, merely by way of example, in the accompanying drawings, in which:-

Figure 1 is a block diagram of an embodiment of a phase locked oscillator circuit according to the present invention;

Figure 2 is a circuit diagram of part of the phase locked oscillator circuit of Figure 1;

Figure 3 is a circuit diagram of a wide band signal generator shown in Figure 2; and

Figure 4 is a diagram showing the magnitude of a current introduced to a charge pump of the phase locked oscillator circuit of Figure 1 over a period of time.

Briefly, the present invention introduces an increment current into a phase lock loop circuit at very specific times. The increased current is introduced during every even pulse in a PLO sync zone. The result is that the increased current associated with every even pulse biases the voltage controlled oscillator toward phase locking onto the even pulses. By introducing increased amounts of current larger phase shifts in the frequency of a read clock are produced while maintaining loop gain of the circuit. Consequently, the circuit locks on more quickly.

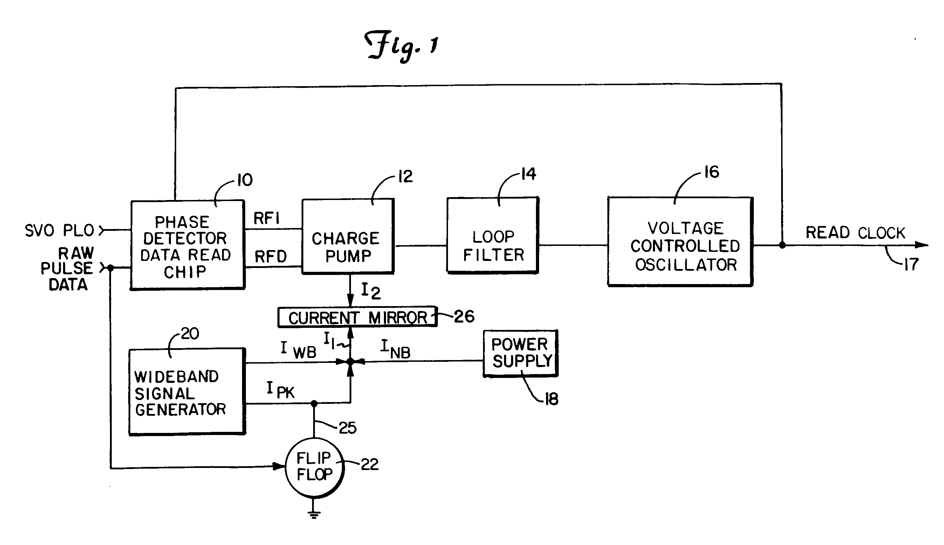

Referring to Figure 1 there is shown a phase locked oscillator circuit according to the present invention. The circuit includes means for recovering data such as a data recovery chip 10, a charge pump 12, a loop filter 14, a voltage controlled oscillator 16 which produces a read clock signal 17, a power supply 18 and means for selectively adding current from a second source such as a wide band signal generator 20. The power supply 18 produces a first source of current, a narrow band current $I_{NB}$, which is sent to the charge pump 12. The narrow band current $I_{NB}$ flows constantly during the operation of the phase locked oscillator circuit.

The wide band signal generator 20 produces a second source of current during a PLO sync zone comprising a wide band current $I_{WB}$, and a peak current $I_{PK}$. The wide band current $I_{WB}$ is relatively small and is sent to the charge pump 12 throughout the PLO sync zone. The peak current $I_{PK}$ is a current which exponentially decays over time. The peak current $I_{PK}$ flows into the charge pump 12 during every even pulse occurring within the PLO sync zone. A flip-flop 22 is triggered by a data pulse or some other signal indicating each data pulse. The flip-flop 22 acts as a switch which alternates between a first position where the peak current $I_{PK}$ flows to the charge pump 12 and a second position where the peak current $I_{PK}$ flows to ground. Consequently, the peak current $I_{PK}$ flows into the charge pump only when the flip-flop is in the first position. It should be noted that the time periods during which the flip-flop 22 allows the peak current $I_{PK}$ to flow to the charge pump 12 are designated as even pulses for the sake of convenience. The times when the flip-flop 22 introduces the peak current $I_{PK}$ to the charge pump 12 could be also denoted as odd pulses. During every odd pulse the flip-flop 22 connects the peak current $I_{PK}$ to ground thereby dissipating the peak current $I_{PK}$.

The data recovery chip 10 has a raw pulse data signal and a servo PLO signal as inputs. The data read chip 10 has phase detector circuitry which receives the read clock signal 17 and compares it against sync or data pulses. The leading edge of a data or sync pulse turns on a read frequency increment signal RFI. At the leading edge of the read clock signal 17, the signal RFI turns off and a read frequency decrement signal RFD turns on. The signal RFD turns off at the next trailing edge of the read clock signal 17. The signal RFD is essentially constant. The signal RFI varies depending upon where the data pulse occurs. When the data pulses are synchronised with the read clock signal 17, the signal RFI and the signal RFD cancel out. If the data pulse and the read clock signal are not synchronised a net read frequency increment signal NRFI or net read frequency decrement signal NRFD will be produced depending upon whether the read clock signal lags or leads the data pulses. Both of the signals RFD and RFI are input to the charge pump 12.

The charge pump 12 provides a current source for the loop filter 14 and adjusts that current depending upon whether a signal RFI or a signal RFD is input to the charge pump 12. Thus, current from the charge pump 12 is adjusted by the signals RFI and RFD to adjust the voltage to the voltage controlled oscillator 16, thereby changing the frequency of the read clock signal 17 to the data recovery chip 10.

After the data in the PLO sync zone is read and the circuit is locked onto the data, only the narrow band current $I_{NB}$, is added to or subtracted from the loop filter 14. When the phase locked oscillator circuit is operating in the PLO sync zone, the charge pump also adds or subtracts the wide band current $I_{WB}$ and the peak current $I_{PK}$ to or from the current in the loop filter 14.

Adjustments to the current in the loop filter 14 also varies the voltage to the voltage controlled oscillator 16. The variations in voltage and the variations in the frequency of the voltage controlled oscillator are larger in the presence of increased current amounts. Consequently, the corrections in the frequency are larger during the PLO sync zone when the wide band current $I_{WB}$ and the peak current $I_{PK}$ are input into the charge pump 12. The corrections to the frequency are the largest during the even pulses when the peak current $I_{PK}$ has a value other than zero.

The peak current $I_{PK}$ varies over time. The peak current $I_{PK}$ is highest initially and decays exponentially from its initial high value over the time of the PLO sync zone. As a result, the frequency correction will initially be large for the first even pulse and will exponentially decay for successive even pulses over the time of the PLO sync zone. Thus, the phase locked oscillator circuit will be biased towards phase locking during the PLO sync zone with greatest biasing occurring on the even pulses. Further, the even pulse biasing will decrease exponentially over the time of the PLO sync zone.

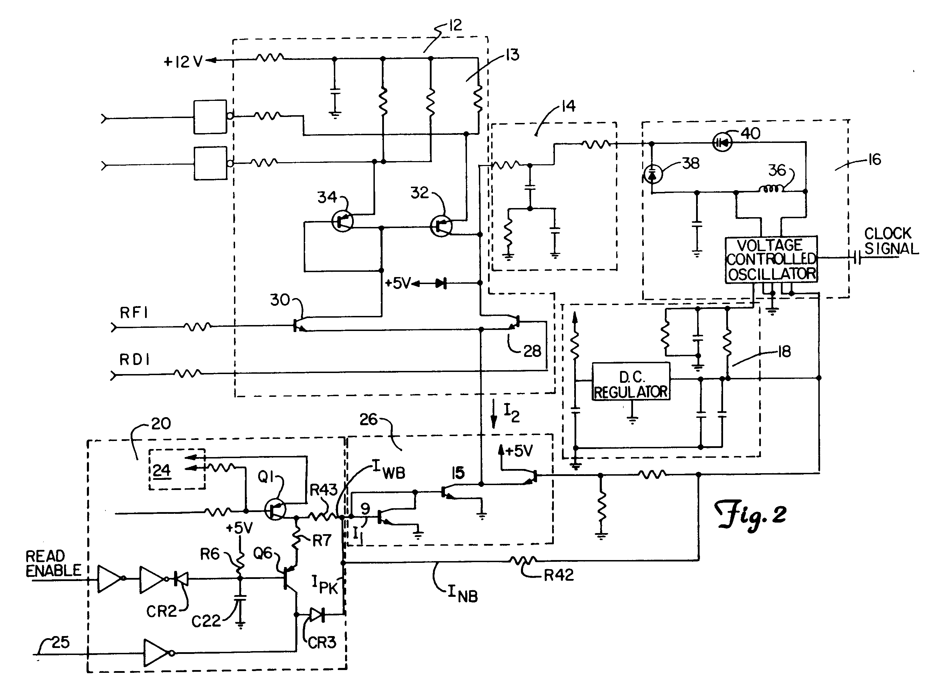

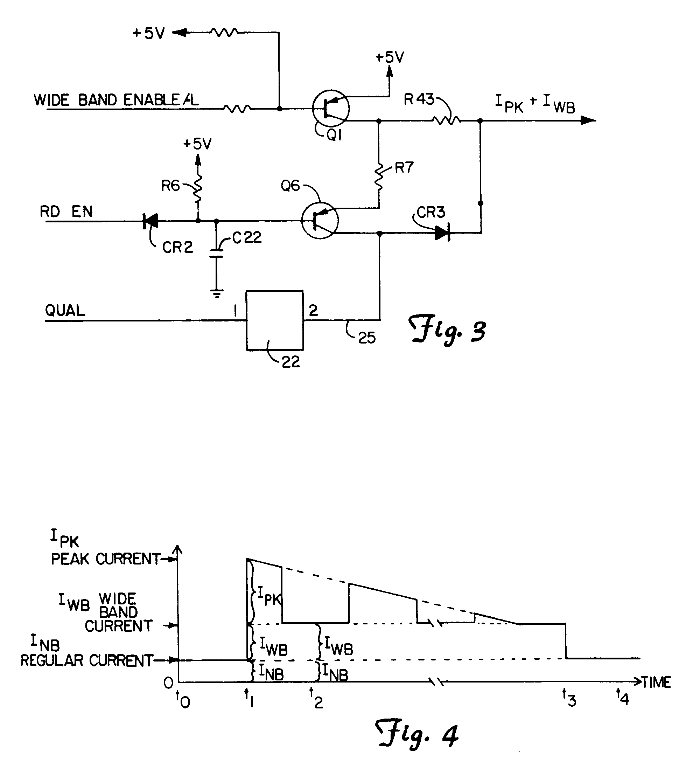

Now referring to Figures 2 and 3, details of the phase locked oscillator circuit and its operation will be discussed.

The wide band current generator 20 controls the magnitude of the increased wide band current $I_{WB}$ and the peak current $I_{PK}$ and the time when the increased current is input to the charge pump 12.

A wide band current source 24 produces the additional current. During the PLO sync zone wide band enable and read enable signals are set to open transistors Q1 and Q6. Current flows through a resistor R7 and through a resistor R43. The current flowing through the resistor R43 is the wide band current $I_{WB}$ and the current flowing through the resistor R7 is the peak current $I_{PK}$. Transistor Q6 varies the emitter-collector current passing through it so that the peak current $I_{PK}$ decays exponentially during the time of the PLO sync zone. Thus, by the end of the PLO sync zone the peak current $I_{PK}$ will be reduced to a value depending on the exponential time constant. Typically it will be close to zero.

A resistor R6 and a capacitor C22 control the decay of the read enable signal entering the base of the transistor Q6. The read enable signal passes through a diode CR2 to charge the capacitor C22 which is dissipated by the resistor R6. The result is a read enable signal that decays exponentially over time. Since the transistor Q6 acts as an amplifier, the peak current $I_{PK}$ that passes through the transistor Q6 also decays exponentially.

The flip-flop 22 (not shown in Figure 2) is connected at a lead 25 and is triggered by each data pulse to alternate states. On the odd data pulses, the flip-flop 22 closes the circuit to ground thus shorting the peak current $I_{PK}$ to ground through the lead 25. Thus during the odd pulses the value of the peak current $I_{PK}$ is set to zero. On the even pulses of the peak current $I_{PK}$, the flip-flop 22 is set to block the flow of the peak current $I_{PK}$ through the lead 25 so that the peak current $I_{PK}$ flows through a diode CR3. The peak current $I_{PK}$ and the wide band current $I_{WB}$ are summed with the narrow band current $I_{NB}$ coming from the power supply 18 and passing through a resistor R42 for input to a current mirror 26.

The sum of the peak current $I_{PK}$, the wide band current $I_{WB}$ and the narrow band current $I_{NB}$ equals current $I_1$ which passes to the current mirror 26. The current mirror 26 draws equal amounts of current from two inputs. In Figure 2, current $I_1$ is applied to input 9 of the current mirror 26 and as a result current $I_2$ is drawn to input 15 of the current mirror 26 from the charge pump 12. Current $I_2$ is equal to current $I_1$ and both flow into the current mirror 26. Both current $I_1$ and current $I_2$ flow to ground.

Data pulses and servo PLO data are input to the data recovery chip 10. The data recovery chip 10 receives the read clock signal 17. The data recovery chip 10 includes other phase detector circuitry which detects the various pulses and produces either the read frequency increment or the read frequency decrement signals, depending upon whether the read data lags or leads the read clock as is well-known in the art.

In Figure 2, only the read frequency increment and read frequency decrement signals, the outputs of the data chip 10, are shown as inputs to the charge pump 12.

In operation, the charge pump 12 includes a current source 13 and adds current to or subtracts current from the loop filter 14 based upon whether the signal RFI or the signal RFD is output to the charge pump 12 from the data recovery chip 10.

Referring to Figure 2, the charge pump 12 includes a first pair of transistors 28 and 30, and a second pair of transistors 32 and 34. The first pair of transistors are identical. Both pair of transistors act as switches. The transistor 30 is opened by a read frequency increment signal from the data recovery chip 10 and the transistor 28 is opened by a read frequency decrement signal from the data recovery chip 10. When the transistor 28 opens in response to a read frequency decrement signal it acts as a switch and the current $I_2$ flows out of the loop filter 14 through the transistor 28 and to the input 15 of the current mirror 26. The transistor 32 is closed when the charge pump 12 responds to a read frequency decrement signal and, as a result, no current flows from the current source 13 to the charge pump 12. As a result, the current $I_2$ flows from the loop filter 14 when a read frequency decrement signal is input to the charge pump 12.

A read frequency increment signal opens the transistor 30. The opening of the transistor 30 triggers the opening of both transistor 32 and transistor 34. Current then takes one of two paths from the current source 13 of the charge pump 12. The current $I_2$ is drawn to output 15 of the current mirror 26 through one current path. The current $I_2$ flows through the transistor 34, through transistor 30 and then to output 15 of the current mirror 26. The other path is from a current source 13 of the charge pump 12 through the transistor 32 and to the loop filter 14. Thus, current travels to the output 15 of the current mirror 26 and to the loop filter 14 when a read frequency increment signal is input to the charge pump 12.

The frequency change in the read clock signal from the voltage controlled oscillator 16 is fed back to the data recovery chip 10 and to the phase detector circuitry therein. When the phase detector circuitry in the data recovery chip 10 detects a raw data pulse, a signal RFI followed by a signal RFD is generated. When the width of the signal RFI equals the width of the signal RFD the raw data pulse is exactly centred in the detection window. When the signal RFI is narrower than the signal RFD a net signal is produced indicating that the raw data pulse is late in the detection window. The signal RFD produces a frequency decrease in the voltage controlled oscillator 16. The net frequency decrease shifts the phase of the read clock signal 17 in a direction so that the next raw data pulse will be more nearly centred. When the signal RFI is wider than the signal RFD a signal RFI is produced indicating that the raw data pulse is early in the detection window. The signal RFI produces a frequency increase which correspondingly shifts the phase of the read clock signal 17. This phase shift moves the detection window in a direction so that the next raw data pulse will be more nearly centred. These corrections occur continually during a read process. The gain of the phase locked oscillator circuit in narrow band is not great enough to allow an individual raw pulse to cause any substantial phase shift. Thus, the feedback loop acts constantly to monitor and correct the phase locked oscillator circuit in the read clock signal.

The loop filter 14 is an array of resistors and capacitors which control the band width and loop response of the phase locked oscillator circuit.

The current adjustments to the loop filter 14 result in an increase or decrease in the amount of voltage applied to the voltage controlled oscillator 16. The voltage controlled oscillator 16 includes a coil 36, a first varactor 38 and a second varactor 40. The current flowing from the loop filter 14 to the voltage controlled oscillator 16 is stored in the varactor 38, the varactor 40 and the coil 36. The varactors and the coil form an LC circuit and alternately store the energy to produce the operating frequency of the voltage controlled oscillator 16 and the frequency of the read clock signal 17. Changes in the amount of current to the loop filter 14 affect the frequency of the voltage controlled oscillator 16 as the varactors and coil will alternate the different amounts of energy they store at different times.

The power supply 18 for the narrow band current $I_{NB}$ is a DC regulator which regulates a twelve volt input down to a regulated five volt output. The capacitors and resistors in the power supply 18 filter out noise and ripple and produce a regulated wave shape shape for the voltage controlled oscillator.

Referring to Figure 4, the magnitude of the current $I_1$ which is supplied to the current mirror 26 (not shown in Figure 4), is shown graphically as a function of time. The narrow band current $I_{NB}$, which comes from the current supply 18, is constant throughout the operation of the phase locked oscillator circuit The wide band current $I_{WB}$ is turned on during the PLO sync zone. The wide band current $I_{WB}$ is also constant during the PLO sync zone and is added to the narrow band current $I_{NB}$ during the PLO sync zone.

The peak current $I_{PK}$ is highest at the beginning of the PLO sync zone and decays throughout the time of the PLO sync zone. The peak current $I_{PK}$ is only summed with the wide band current $I_{WB}$ and the narrow band current $I_{NB}$ when the flip-flop 22 is in the position where the peak current $I_{PK}$ does not short to ground. When the flip-flop 22 connects the peak current $I_{PK}$ toground its value becomes zero.

Referring to Figure 4, from $t_0$ to $t_1$ the magnitude of the current equals the narrow band current $I_{NB}$. At $t_1$, the PLO sync zone begins. At $t_1$, the flip-flop 22 operates so that the peak current $I_{PK}$ is input from the current mirror. The wide band current $I_{WB}$ is also added to the current mirror. As a result the magnitude of the input to the current mirror equals $I_{NB} + I_{WB} + I_{PK}$. At $t_2$, the flip-flop closes to ground setting the peak current $I_{PK}$ to zero and the magnitude of the current equals $I_{WB} + I_{NB}$. The narrow band current $I_{NB}$ and the wide band current $I_{WB}$ represent the constant magnitude of current during the PLO sync zone. This cycle repeats as the flip-flop switches the peak current $I_{PK}$ between ground and the current mirror. The magnitude of the peak current $I_{PK}$ drops as it decays over time. At $t_3$ the PLO sync zone ends and the wide band current $I_{WB}$ drops to zero. At $t_4$, the current sent to the current mirror equals the narrow band current $I_{NB}$ since the wide band current generator 20 only operates during the PLO sync zone. It should be noted that the decay function depicted by Figure 4 is merely illustrative.

**Claims**

1. A phase locked oscillator circuit for phase locking a clock signal to the phase of a series of sync pulses, characterised by comprising: clock signal producing means (16) for producing a clock signal (17) having a frequency responsive to a first signal; a loop filter (14) for applying the first signal to clock signal producing means (16) in response to a current signal, comparing means (10, 12) including a charge pump (12) for adding to or subtracting from the loop filter (14) a second signal ($I_2$) in response to the phase relationship between the clock signal and the series of sync pulses; means (20, 22) for generating a third signal ($I_{WB}$, $I_{PK}$) of decreasing value during the presence of the sync pulses; means (18) for providing a constant current fourth signal ($I_{NB}$), and a current mirror (26) for producing the second signal ($I_2$) in response to the third signal ($I_{WB}$, $I_{PK}$) and the fourth signal ($I_{NB}$).

2. A circuit as claimed in claim 1 characterised in that a summation ($I_1$) of the third and fourth signals determines the magnitude of a frequency change produced by the first signal.

3. A circuit as claimed in claim 1 or 2 characterised in that the said means (20,22) for generating the third signal ($I_{WB}$, $I_{PK}$) comprises a substantially constant signal portion (24), shorting means (22) for shorting a signal to ground upon every other sync pulse, and a decaying signal portion ($R_6$, $C_{22}$) electrically connected to the shorting means so that the decaying signal portion drops to zero on every other sync pulse, the substantially constant signal portion and the decaying signal portion being summed to produce the third signal ($I_{WB}$, $I_{PK}$).

4. A circuit as claimed in claim 3 characterised in that said shorting means includes a flip-flop (22) acting as a switch which alternates between an open position and a closed position connected to ground.

5. A circuit as claimed in any preceding claim characterised in that said clock signal producing means is a voltage controlled oscillator (16) the first signal produced by the means (26) for adjusting the level of current varies the voltage in the circuit near the voltage controlled oscillator thereby varying the frequency of the read clock signal.

6. A circuit as claimed in claim 5 characterised in that the voltage in the circuit near the voltage controlled oscillator (16) increases in response to the read frequency increment signal (RFI) to increase the frequency of the read clock signal and the voltage in the circuit near the voltage controlled oscillator decreases in response to the read frequency decrement signal (RFD) to decrease the frequency of the clock signal.

**Revendications**

1. Circuits d'oscillateur à verrouillage de phase pour le verrouillage en phase d'un signal d'horloge suivant la phase d'une série d'impulsions de synchronisation, caractérisé en ce qu'il comprend : un moyen de production de signaux d'horloge (16) pour émettre un signal d'horloge (17) ayant une fréquence réagissant à un premier signal ; un filtre de boucle (14) pour appliquer le premier signal au moyen de production de signaux d'horloge (16) en réponse à un signal de courant, un moyen de comparaison (10, 12) comprenant une pompe de charge (12) pour ajouter au filtre de boucle (14) ou en soustraire un deuxième signal ($I_2$) en réponse à la relation de phase entre le signal d'horloge et la suite d'impulsions de synchronisation ; un moyen (20, 22) pour produire un troisième signal ($I_{WB}$, $I_{PK}$) de valeur décroissante pendant la présence des impulsions de synchronisation ; un moyen (18) pour fournir un quatrième signal de courant constant ($I_{NB}$) et un miroir de courant (26) pour produire le deuxième signal ($I_2$) en réponse au troisième signal ($I_{WB}$, $I_{PK}$) et au quatrième signal ($I_{NB}$).

2. Circuit suivant la revendication 1, caractérisé en ce qu'une totalisation ($I_1$) des premier et quatrième signaux détermine l'amplitude d'une variation de fréquence produite par le premier signal.

3. Circuit suivant la revendication 1 ou la revendication 2, caractérisé en ce que ledit moyen (20, 22) pour produire le troisième signal ($I_{WB}$, $I_{PK}$) comprend une partie de signal sensiblement constant (24), un moyen de court-circuit (22) pour court-circuiter un signal à la terre toutes les deux impulsions de synchronisation, et une partie de signal décroissant ($R_6$, $C_{22}$) électriquement reliée au moyen de court-circuit de telle manière que la partie de signal décroissant tombe à zéro toutes les deux impulsions de synchronisation, la partie de signal sensiblement constant et la partie de signal décroissant étant additionnées pour produire le troisième signal ($I_{WB}$,$I_{PK}$).

4. Circuit suivant la revendication 3, caractérisé en ce que ledit moyen de court-circuit comprend une bascule (22) faisant fonction de commutateur passant en alternance entre une position ouverte et une position fermée reliée à la terre.

5. Circuit suivant l'une quelconque des revendications précédentes, caractérisé en ce que ledit moyen de production de signaux d'horloge est un oscillateur commandé en tension (16), le premier signal produit par le moyen (26) pour ajuster le niveau du courant faisant varier la tension dans le circuit à proximité de l'oscillateur commandé en tension, ce qui modifie la fréquence du signal d'horloge de lecture.

6. Circuit suivant la revendication 5, caractérisé en ce que la tension à proximité de l'oscillateur commandé en tension (16) augmente en réponse au signal d'incrément de fréquence de lecture (RFI) pour augmenter la fréquence du signal d'horloge de lecture et que la tension dans le circuit à proximité de l'oscillateur commandé en tension décroît en réponse au signal de décrément de fréquence de lecture (RFD) pour réduire la fréquence du signal d'horloge.

**Patentansprüche**

1. Phasensynchronisierte Oszillatorschaltung zur Phasensynchronisation eines Taktsignals mit der Phase einer Serie von Synchronisationsimpulsen,
**gekennzeichnet** durch:
eine Taktsignal-Generatoreinrichtung (16) zur Erzeugung eines Taktsignals (17) mit einer von einem ersten Signal abhängigen Frequenz, ein Schleifenfilter (14) zur Zuführung des ersten Signals an die Taktsignal-Generatoreinrichtung (16) in Abhängigkeit von einem Stromsignal, eine Ladungspumpe (12) einschließende Vergleichereinrichtungen (10,12) zum Addieren oder Subtrahieren eines zweiten Signals ($I_2$) von dem Schleifenfilter in Abhängigkeit von der Phasenbeziehung zwischen dem Taktsignal und der Serie von Synchronisationsimpulsen, eine Einrichtung (20,22) zur Erzeugung eines dritten Signals ($I_{WB}$,$I_{PK}$) mit abnehmendem Wert während des Vorhandenseins der Synchronisationsimpulse, Einrichtungen (18) zur Lieferung eines vierten Konstantstromsignals ($I_{NB}$), und einen Stromspiegel (26) zur Erzeugung des zweiten Signals ($I_2$) in Abhängigkeit von dem dritten Signal ($I_{WB}$,$I_{PK}$) und von dem vierten Signal ($I_{NB}$).

2. Schaltung nach Anspruch 1,
dadurch **gekennzeichnet,** daß eine Summie-

rung ($I_1$) der dritten und vierten Signale die Größe einer Frequenzänderung bestimmt, die durch das erste Signal hervorgerufen wird.

3. Schaltung nach Anspruch 1 oder 2,
dadurch **gekennzeichnet,** daß die Einrichtung (20, 22) zur Erzeugung des dritten Signals ($I_{WB}$,$I_{PK}$) einen ein im wesentlichen konstantes Signal ergebenden Teil (24), eine Kurzschlußeinrichtung (22) zum Kurzschließen eines Signals gegen Erde bei jedem zweiten Synchronisationsimpuls, und einen Abkling-Signalteil ($R_6$,$C_{22}$) umfaßt, der elektrisch mit der Kurzschlußeinrichtungen verbunden ist, so daß der Abkling-Signalteil bei jedem zweiten Synchronisationsimpuls auf Null abfällt und wobei der im wesentlichen konstante Signalteil und der Abkling-Signalteil summiert werden, um das dritte Signal ($I_{WB}$,$I_{PK}$) zu erzeugen.

4. Schaltung nach Anspruch 3,
dadurch **gekennzeichnet,** daß die Kurzschlußeinrichtung eine Flip-Flop-Schaltung (22) einschließt, die als Schalter wirkt, der zwischen einer offenen Stellung und einer mit Erde verbundenen geschlossenen Stellung wechselt.

5. Schaltung nach einem der vorhergehenden Ansprüche,
dadurch **gekennzeichnet,** daß die Taktsignal-Generatoreinrichtung ein spannungsgesteuerter Oszillator (16) ist, daß das von den Einrichtungen (26) zur Einstellung des Pegels des Stromes erzeugte erste Signal die Spannung in der Schaltung in der Nähe des spannungsgesteuerten Oszillators ändert, wodurch die Frequenz des Lese-Taktsignals geändert wird.

6. Schaltung nach Anspruch 5,
dadurch **gekennzeichnet,** daß die Spannung in der Schaltung in der Nähe des spannungsgesteuerten Oszillators (16) in Abhängigkeit von dem Lesefrequenz-Inkrementsignal (RFI) ansteigt, um die Frequenz des Lese-Taktsignals zu erhöhen, und daß die Spannung in der Schaltung in der Nähe des Spannungsgesteuerten Oszillators in Abhängigkeit von dem Lesefrequenz-Dekrementsignal (RFD) absinkt, um die Frequenz des Taktsignals zu verringern.

Fig. 1

Fig.2

+5V

+5V

WIDE BAND ENABLE/L

$I_{PK} + I_{WB}$

R 43

Q1

R7

+5V

R6

Q6

RD EN

CR2

C22

CR3

QUAL

1

2

25

22

*Fig. 3*

$I_{PK}$
PEAK CURRENT

$I_{WB}$ WIDE BAND CURRENT

$I_{NB}$ REGULAR CURRENT

$I_{PK}$

$I_{WB}$

$I_{WB}$

$I_{NB}$

$I_{NB}$

O

$t_0$

$t_1$

$t_2$

$t_3$

$t_4$

TIME

*Fig. 4*